Europäisches Patentamt

European Patent Office

Office européen des brevets

(19)

(11) EP 0 754 953 B1

(12) **FASCICULE DE BREVET EUROPEEN**

(45) Date de publication et mention
de la délivrance du brevet:
**20.06.2001 Bulletin 2001/25**

(51) Int Cl.⁷: **G01P 15/08**

(21) Numéro de dépôt: **96401625.7**

(22) Date de dépôt: **19.07.1996**

(54) **Procédé de fabrication d'une structure avec une couche utile maintenue à distance d'un substrat par des butées, et de désolidarisation d'une telle couche**

Verfahren zur Herstellung einer Struktur mit einer mittels Anschlägen auf Abstand von einem Substrat gehaltenen Nutzschicht, sowie Verfahren zur Loslösung einer solchen Schicht

Method of manufacturing a structure with an usable layer, which is kept at a distance from a substrate by limit stops, and method for disjoining such a layer

(84) Etats contractants désignés:
**DE GB IT**

(30) Priorité: **21.07.1995 FR 9508882**

(43) Date de publication de la demande:
**22.01.1997 Bulletin 1997/04**

(73) Titulaire: **COMMISSARIAT A L'ENERGIE ATOMIQUE**
**75015 Paris (FR)**

(72) Inventeurs:
• **Bono, Hubert**
**38960 Haute Jarrie (FR)**

• **Michel, France**
**38360 Sassenage (FR)**
• **Rey, Patrice**
**38430 St Jean De Moirans (FR)**

(74) Mandataire: **Dubois-Chabert, Guy et al**
**BREVATOME**
**3, rue du Docteur Lanceraux**
**75008 Paris (FR)**

(56) Documents cités:
**EP-A- 0 605 300       DE-A- 4 317 274**
**US-A- 4 999 735       US-A- 5 258 097**

EP 0 754 953 B1

# Description

Domaine technique

La présente invention concerne un procédé de désolidarisation d'une couche utile reliée à un substrat par l'intermédiaire d'une couche sacrificielle.

Elle concerne également un procédé de fabrication d'une structure avec une couche utile maintenue à distance d'un substrat par des butées formées dans la couche utile et/ou le substrat.

On entend par couche utile une couche de matériau ou une portion d'une telle couche entrant dans la fabrication en particulier d'une structure de type micromécanique.

L'invention trouve des applications en particulier pour la fabrication de microactionneurs, de micropompes, de micromoteurs, d'accéléromètres, de capteurs à détection électrostatique ou électromagnétique et plus généralement pour la fabrication de tout système de micromécanique impliquant l'utilisation d'une couche sacrificielle.

Etat de la technique antérieure

Lorsque la fabrication d'un système de micromécanique requiert une séparation de certaines parties de ce système à une distance de l'ordre de, ou inférieure au micron, on utilise usuellement une couche sacrificielle.

Cette couche sacrificielle permet de contrôler la distance entre les parties en interaction et de préserver l'intégrité du système au cours des différentes étapes de fabrication.

Le contrôle des distances entre des parties en interaction est essentiel pour obtenir des systèmes de micromécanique performants. En effet lors de leur fabrication, les phénomènes physiques mis en jeu dépendent généralement des puissances négatives de la distance d'interaction. Quel que soit le mode de réalisation de la couche sacrificielle, celle-ci est gravée par un procédé suffisamment sélectif pour ne pas altérer la structure environnante du système de micromécanique et, en particulier, les parties que la couche sacrificielle reliait. Lorsque la couche sacrificielle est éliminée, une ou plusieurs de ces parties sont généralement mobiles.

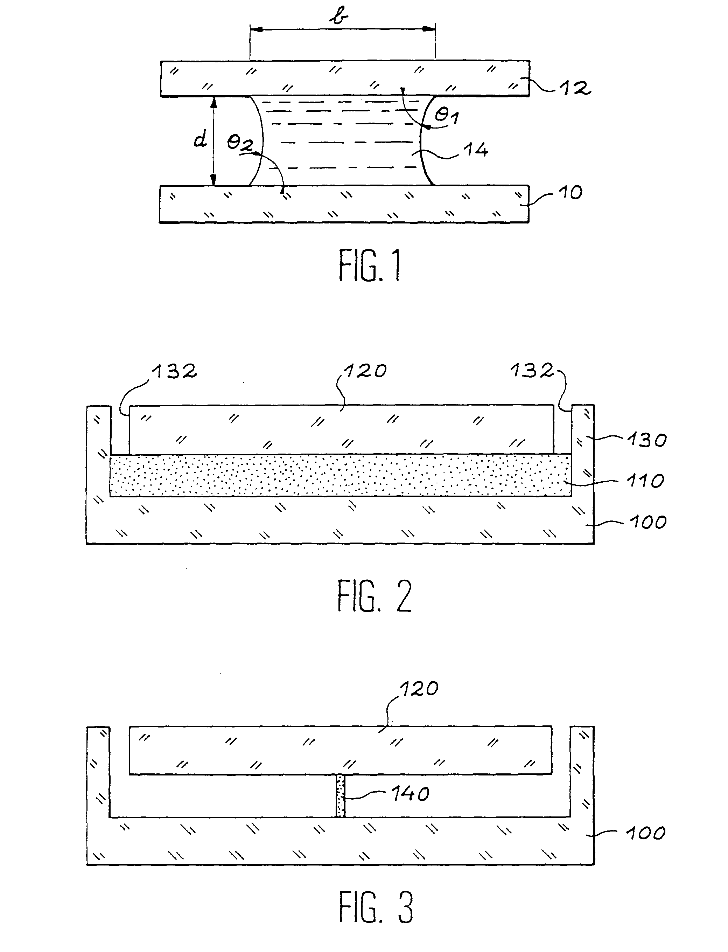

Dans la plupart des cas, la gravure de la couche sacrificielle est effectuée par voie chimique. Après une telle gravure se pose le problème délicat du séchage du solvant utilisé pour le rinçage de la structure. En effet, au cours du séchage, les parties mobiles sont soumises à des forces attractives induites par la courbure de l'interface liquide vapeur du solvant, comme le montre la figure 1. Ces forces de capillarité proviennent de la tension superficielle du liquide de rinçage en équilibre avec sa vapeur sur le solide.

La figure 1 est une coupe très schématique d'une structure de micromécanique en cours de séchage après l'élimination par voie chimique d'une couche sacrificielle. Entre les parties 10 et 12 de cette structure, initialement reliées par la couche sacrificielle se trouve un reliquat 14 de solvant. On désigne par θ1 et θ2 les angles de mouillage aux points triples liquide/solide/vapeur, par b la longueur de l'interface liquide/solide et par d la distance entre les parties 10 et 12. Ainsi, l'expression de la force transverse linéique q qui s'exerce sur les parties 10 et 12 est donnée par la relation suivante :

$$q = \frac{\gamma \cdot (\cos \theta_1 + \cos \theta_2) \cdot b}{d}$$

où $\gamma$ est la tension superficielle liquide/solide.

Durant le séchage du solvant 14 la distance d diminue du fait de forces de capillarité s'exerçant sur les parties 10 et 12. Ceci a pour effet d'augmenter ces mêmes forces, et ce jusqu'au collage inéluctable des parties mobiles 10 et 12. De plus, lorsque la distance entre les parties 10 et 12 est de l'ordre de grandeur des distances interatomiques, les forces d'attraction deviennent de type Van Der Walls, et le collage devient irréversible.

Ce collage s'oppose à la mobilité des parties 10 et/ou 12 et compromet la fabrication de la structure micromécanique.

Pour résoudre le problème du collage, il est possible d'agir soit sur le paramètre physico-chimique de la tension superficielle ($\gamma$), soit sur des paramètres géométriques de la structure à réaliser.

En effet pour éviter le collage, une solution consiste à diminuer, voire à annuler la tension superficielle. Dans le document (1) référencé à la fin de la présente description, G. Mulhern propose de supprimer l'interface liquide/vapeur en ayant recours à des conditions de température et pression dites supercritiques. Dans ces conditions, le liquide et la vapeur ne peuvent être différenciés. Ainsi, l'interface liquide-vapeur, et donc la tension superficielle n'existent plus. A titre d'exemple, lorsque la silice est utilisée comme couche sacrificielle, celle-ci est gravée par une solution d'acide fluorhydrique. Après la gravure, la structure est rincée avec de l'eau désionisée qui est, elle-même, rincée avec du méthanol par dilution. A son tour, le méthanol est dilué par du dioxyde de carbone liquide dans une enceinte portée à une pression de l'ordre de 80 atmosphères. Après la disparition du méthanol, l'enceinte est isolée et portée à une température de 35°C ce qui a pour effet d'augmenter la pression et dépasser la transition supercritique. Il ne reste plus qu'à évacuer le dioxyde carbone et revenir à la pression atmosphérique.

Une autre possibilité pour éviter le collage entre des parties d'une structure, séparées par élimination d'une couche sacrificielle, consiste à limiter les surfaces en contact de ces parties au cours du séchage, et ainsi, rendre le séchage réversible. Pour cela il suffit que des forces de rappel agissant sur la ou les parties (mobiles) soient supérieures aux forces attractives qui sont proportionnelles à la surface des parties en contact.

Le problème de collage peut aussi se produire si les deux surfaces viennent en contact à cause d'une sollicitation extérieure. Dans le document (2) référencé à la fin de la présente description, Wiegand propose un accéléromètre à détection capacitive constitué de trois substrats usinés indépendamment puis scellés. Le substrat central constitue une masse sismique, tandis que les substrats supérieur et inférieur comportent des butées qui limitent la surface de contact avec la masse sismique en cas de rapprochement.

Dans le document (3) référencé à la fin de la présente description, Wilner propose le même type d'assemblage mais en plaçant les butées sur le substrat central dans lequel est usiné la masse sismique.

Dans le document (4) référencé à la fin de la présente description, les auteurs proposent une structure d'accéléromètre réalisée par un empilement de couches. Dans ce cas, une dépression est réalisée dans une couche sacrificielle recouverte par une couche dans laquelle la masse sismique est usinée. Après gravure de la couche sacrificielle la dépression est remplacée par une butée sur la partie mobile.

Une autre solution encore pour éviter le collage des parties 10, 12 d'une structure conforme à la figure 1, après l'élimination de la couche sacrificielle, peut être d'augmenter la rugosité des surfaces en regard de ces parties, et donc de limiter les forces d'adhésion en cas de collage. Alley R. et co-auteurs montrent comment réaliser et contrôler cette rugosité.

Un procédé de fabrication d'une microstructure est connu aussi dans le document (5).

Tous les procédés évoqués ci-dessus supposent que les surfaces susceptibles d'entrer en contact puissent être accessibles et usinables en cours de fabrication. Malheureusement pour améliorer les performances des systèmes de micromécanique, il est souvent nécessaire de diminuer l'épaisseur de la couche sacrificielle et d'avoir un matériau de bonne qualité. De plus, pour des raisons de compatibilité technologique avec les réalisations de microélectronique, le matériau le plus utilisé en micromécanique est le silicium monocristallin. Compte tenu de ces deux exigences, on a souvent recours à des substrats de type silicium sur isolant. Ces substrats sont constitués d'un substrat de silicium recouvert d'une couche mince d'isolant, généralement de silice, qui est elle-même recouverte d'une couche mince de silicium monocristallin. La couche isolante fait office de couche sacrificielle, si bien qu'il est impossible d'usiner les surfaces susceptibles d'entrer en contact. La plupart des techniques décrites ci-dessus et permettant d'éviter le collage ne sont donc plus applicables.

Un but de la présente invention est justement de proposer un procédé de désolidarisation d'une couche utile de matériau reliée initialement à un substrat par une couche sacrificielle, permettant d'éviter les problèmes de collage mentionnés ci-dessus.

Un autre but de la présente invention est aussi de proposer un procédé de fabrication d'une structure comportant une couche utile maintenue à distance d'un substrat par des butées, qui soit à la fois compatible avec les techniques des structures du type silicium sur isolant, les techniques de microélectronique et avec les exigences de fabrication de structures avec des couches sacrificielles très fines.

Exposé de l'invention

Pour atteindre les buts évoqués ci-dessus, l'invention a pour objet un procédé de désolidarisation d'une couche utile reliée initialement à un substrat par une couche sacrificielle, caractérisé en ce qu'il comporte les étapes suivantes :

- première gravure partielle et sélective de la couche sacrificielle en laissant subsister entre le substrat et la couche utile au moins un pavé formant un espaceur,
- deuxième gravure sélective de la couche utile et/ou du substrat en utilisant l'espaceur comme masque de façon à former au moins une butée dans ladite couche utile et/ou le substrat,
- éliminer ledit espaceur.

La couche utile constitue par exemple l'élément sensible d'un capteur, tel qu'une masse sismique d'un accéléromètre, ou une membrane d'un capteur de pression. Il peut s'agir aussi d'une partie mobile telle que le rotor d'un micromoteur par exemple.

Selon un aspect de l'invention on peut effectuer la première et la deuxième gravures par voie humide à travers au moins une ouverture pratiquée dans la couche utile.

La répartition des butées sur au moins l'une des surface en regard de la couche utile et/ou du substrat peut être est effectuée par un arrangement donné des ouvertures permettant l'accès à la couche intermédiaire et donc sa gravure.

Le nombre des butées formées est minimisé et leur répartition est adaptée pour leur conférer un maximum d'efficacité.

Le nombre et la répartition des butées peuvent avantageusement être choisis de sorte que les parties en regard de la couche utile et du substrat ne puissent pas avoir de flèche de déformation supérieure à une distance finale prédéterminée qui doit les séparer.

En particulier, la première gravure peut être effectuée à partir de chaque ouverture, sur une distance $D$ sensiblement égale à $\frac{L - e}{2}$, où $L$ est la distance maximale entre des ouvertures voisines et $e$ une dimension caractéristique, par exemple la largeur des butées.

L'invention concerne également un procédé de fabrication d'une structure comportant une couche utile maintenue à distance d'un substrat par des butées formées dans la couche utile et/ou le substrat, caractérisé en ce qu'il comporte :

- la formation d'une structure initiale comportant un empilement du substrat, d'une couche sacrificielle et de la couche utile, la couche sacrificielle reliant la couche utile au substrat, et
- la désolidarisation de la couche utile du substrat conformément au procédé décrit ci-dessus.

Dans l'ensemble du texte, on entend par substrat soit une couche épaisse servant de support à la couche utile soit une deuxième couche utile devant être séparée de la couche utile mentionnée ci-dessus.

Selon un aspect de l'invention la structure initiale peut être du type silicium sur isolant.

Une telle structure, a l'avantage d'être usuelle dans les techniques de microélectronique et donc parfaitement compatible avec l'invention.

Selon un aspect particulier de l'invention, le procédé peut être appliqué à la fabrication d'un accéléromètre. Dans ce cas, on équipe la couche utile et le substrat de moyens électriques de mesure d'un déplacement relatif de cette couche utile par rapport au substrat sous l'effet d'une accélération. La couche utile forme la masse mobile sensible d'un tel accéléromètre.

D'autres caractéristiques et avantages de la présente invention ressortiront mieux de la description qui va suivre, donnée à titre purement illustratif et non limitatif, en référence aux figures annexées.

Brève description des figures

- la figure 1, déjà décrite, est une coupe schématique illustrant les problèmes de collage entre deux parties d'une structure après l'élimination d'une couche sacrificielle qui les sépare,
- les figures 2 à 5 sont des coupes schématiques illustrant différentes étapes du procédé de l'invention selon une mise en oeuvre particulière de celle-ci,
- la figure 6 montre, à plus petite échelle un motif d'ouverture pratiqué dans la couche utile de la structure représentée aux figures 2 à 5,
- la figure 7 est une vue schématique de dessus d'un accéléromètre formé par usinage et en mettant en oeuvre l'invention,
- la figure 8 est une coupe VIII-VIII schématique de l'accéléromètre de la figure 7.

Description de modes de mise en oeuvre de l'invention

La figure 2 montre une structure comportant un substrat 100, par exemple de silicium, une couche sacrificielle 110 d'oxyde de silicium encaissée dans le substrat 100 et une couche 120 dite utile, de silicium, recouvrant la couche sacrificielle. Un bord 130 du substrat entoure latéralement la couche sacrificielle.

Dans le mode de mise en oeuvre de l'invention correspondant à cette figure, une première étape consiste à pratiquer des ouvertures 132, par exemple dans la couche utile 120 afin de constituer des voies d'accès à la couche sacrificielle 110. De façon avantageuse, ces ouvertures sont pratiquées dans la couche utile 120 en mettant à profit une opération de gravure destinée à mettre en forme la couche utile.

Les voies d'accès sont utilisées pour la gravure de la couche 110. Dans le cas où la couche sacrificielle 110 est en oxyde de silicium, la gravure peut être réalisée en attaquant cette couche 110 à travers les ouvertures 132 avec de l'acide fluorhydrique.

Lors de la gravure de la couche sacrificielle 110 on laisse subsister entre le substrat 100 et la couche utile 120 un ou plusieurs pavés formant des espaceurs.

Un tel pavé est représenté à la figure 3 avec la référence 140. Un ou plusieurs pavés ainsi formés permettent de maintenir le substrat 100 et la couche utile 120 à une distance égale à l'épaisseur de la couche sacrificielle initiale.

Une deuxième gravure sélective, par exemple avec une solution de potasse, permet d'attaquer le substrat et la couche utile dans l'espace qui les sépare. Lors de cette deuxième gravure qui n'attaque pas les pavés 140, ceux-ci forment des masques et protègent les régions du substrat et de la couche utile sur lesquelles ils prennent appui.

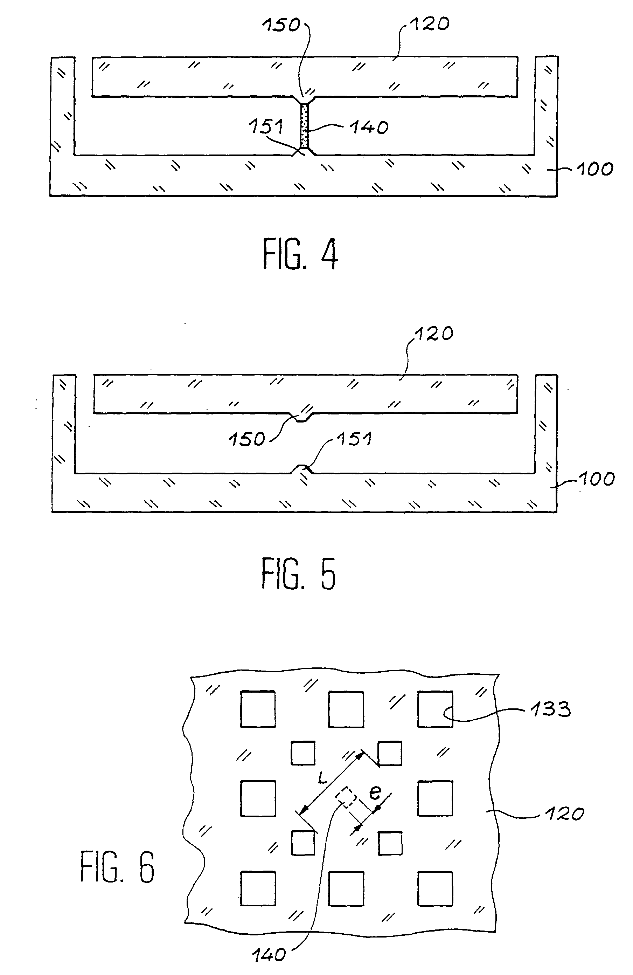

Ainsi, lors de la deuxième gravure, se forment des butées 150, 151 respectivement sur la couche utile et sur le sur le substrat. Ces butées sont représentée sur la figure 4.

Dans le cas de l'exemple décrit, les butées 150 et 151 se font face et sont séparées par le pavé 140. Cependant, il est possible dans une autre réalisation, où le substrat et la couche utile sont réalisés dans des matériaux différents, de n'attaquer lors de la deuxième gravure que l'une de ces parties. Il est ainsi possible également de former sélectivement des butées soit sur le substrat soit sur la couche utile.

Une dernière étape consiste, comme le montre la figure 5, à éliminer lors d'une troisième gravure, les pavés 140 subsistant entre les butées 150 et 151.

Ainsi, à la fin du procédé un espacement est maintenu entre la couche utile et le substrat grâce aux butées 150 et 151. La largeur de cet espacement dépend de la hauteur des butées et donc des conditions (profondeur) de la deuxième gravure.

La figure 6 donne un exemple de motif de gravure des ouvertures 132 dans la couche utile afin de réaliser des butées centrales telles que représentées sur la figure 5. Des carrés avec la référence 133 correspondent aux ouvertures 132 pratiquées dans la couche 120 pour laisser subsister un pavé central 140 de dimension e.

Sur le damier formé par les ouvertures, on désigne par ailleurs par L la distance selon une diagonale entre les ouvertures voisines. Comme indiqué ci-dessus dans la description, la première gravure est réalisée sur une distance sensiblement égale à (L-e)/2, mesurée parallèlement au plan de la couche 120.

De plus, il convient de préciser que la dimension des butées et des pavés n'est pas déterminée par photolithographie, mais par le contrôle de la cinétique des gravures. Ceci permet de réaliser des butées avec des dimensions de l'ordre du micromètre ou inférieures au micromètre. Les paramètres qui déterminent les dimensions et la hauteur des butées sont donc les mêmes que ceux qui gouvernent toute cinétique chimique de gravure, c'est-à-dire la concentration en espèces réactives, la température et le temps.

En pratique, pour la gravure, il suffit d'utiliser une solution de concentration connue, à une température contrôlée et d'agir seulement sur le paramètre temps.

Un exemple particulier d'application du procédé ci-dessus est la réalisation d'un accéléromètre à détection capacitive avec un axe sensible parallèle au substrat.

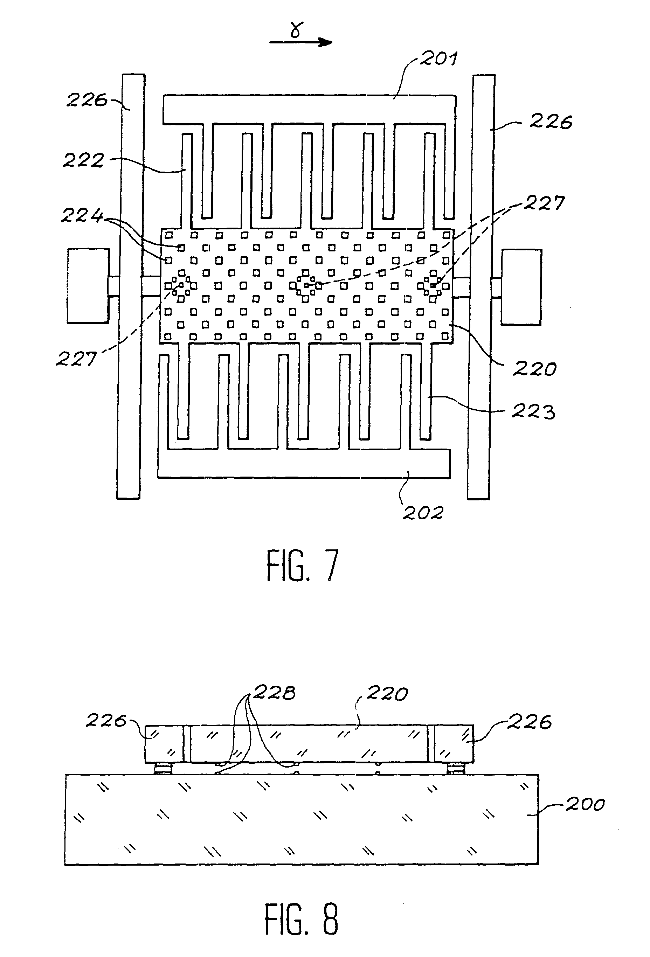

La figure 7 est une vue de dessus d'un tel accéléromètre. Celui-ci comporte une masse sismique 220 mobile, avec des doigts 222, 223 interdigités avec des peignes 201, 202 constituant des parties fixes de l'accéléromètre.

La masse sismique 220 se déplace dans le sens de l'accélération $\gamma$ qui y est appliquée. Sur la figure cette accélération est représentée par une flèche.

Par ailleurs, la masse sismique est maintenue par des poutres 226 présentant une raideur k. En considérant que M est la masse de la partie mobile 220, celle-ci se déplace d'une quantité x exprimée par $x = \frac{M\gamma}{k}$, sous l'effet de l'accélération $\gamma$.

Les peignes 201, 202 et les doigts 222, 223 de la masse sismique forment les armatures de condensateurs électriques.

Dans le cas de la figure 7, un déplacement de la masse sismique correspond par exemple une augmentation de la capacité du condensateur formé entre les doigts 222 et le peigne 201, notée $C_{222\text{-}201}$ et une diminution de la capacité du condensateur formé entre les doigts 223 et le peigne 202 notée $C_{223\text{-}202}$.

Si la distance au repos entre doigts fixes et doigts mobiles est $\ell$, les capacités sont de la forme :

$$C_{222\text{-}201} = \varepsilon \, \frac{S}{\ell - x}$$

$$C_{223\text{-}202} = \varepsilon \, \frac{S}{\ell + x}$$

où $\varepsilon$ est la permittivité du vide et S la surface des électrodes en regard.

La mesure de $(C_{222\text{-}201}) - (C_{223\text{-}202})$, nulle au repos, donne donc une valeur proportionnelle à l'accélération.

L'accéléromètre de la figure 7 est réalisé selon une technique de fabrication planaire à partir d'un substrat de type silicium sur isolant. Ce type de substrat peut être obtenu soit par implantation d'oxygène dans un substrat initial de silicium, soit par scellement de deux substrats dont l'un a été couvert d'une couche mince d'oxyde de silicium. Dans les deux cas, la structure obtenue est constituée de trois couches : une première très épaisse de silicium, une deuxième couche sacrificielle très mince d'oxyde de silicium et une troisième couche de silicium.

Dans le cas du présent exemple, la couche sacrificielle d'oxyde de silicium présente une épaisseur de l'ordre de 0,4 $\mu$m tandis que la troisième couche, ou couche supérieure présente une épaisseur de 10 à 20 $\mu$m.

L'élément sensible de l'accéléromètre, c'est-à-dire la masse sismique mobile 220 est délimité par photolithogravure dans la troisième couche, et constitue la couche utile au sens de la présente invention.

La désolidarisation de cette couche utile est effectuée conformément au procédé exposé ci-dessus. Des ouvertures 224 pratiquées dans la couche utile selon un motif comparable à celui de la figure 6 constituent des voies d'accès à la couche sacrificielle. Ces ouvertures sont pratiquées dans la couche utile avantageusement lors de l'étape de gravure de la troisième couche, définissant la forme de la masse sismique.

Une première gravure partielle de la couche sacrificielle est effectuée par une solution d'acide fluorhydrique. Trois pavés de la couche sacrificielle désignés avec la référence 227 sont préservés entre le substrat et la couche utile, ils présentent une section de l'ordre de 1 $\mu$m.

Après un rinçage par débordement, afin que la structure reste dans un milieu liquide, une gravure sélective du silicium du substrat et de la couche utile 220 est réalisée par une solution de potasse. La couche utile et le substrat sont attaqués sur une profondeur de l'ordre de 0,1 $\mu$m sur chacune des faces en regard. Des butées sont ainsi formées dans les régions protégées par les pavés 227.

A l'issue de cette étape, on effectue le même type de rinçage que précédemment. Pour finir la libération finale de la couche utile, c'est-à-dire de la masse sismique par rapport au substrat, une dernière gravure des pavés d'oxyde de silicium est réalisée par une solution d'acide fluorhydrique en prenant garde à ne pas trop altérer des ancrages pratiqués de part et d'autre de la masse sismique.

Après rinçage et séchage, on obtient la structure de la figure 8. Sur cette figure, on distingue le substrat 200, la niasse sismique 220, les poutres 226 et les butées 228 réalisés conformément au procédé décrit ci-dessus.

Finalement, l'invention permet, dans des applications très variées de réaliser une désolidarisation entre des parties d'une structure de micromécanique sans risque de collage ultérieur de ces parties. Ceci est possible, grâce à l'invention, sans étape de lithographie de gravure supplémentaire, et en ne mettant en jeu que des réactions chimiques connues et simples à réaliser.

De plus, le procédé de l'invention peut être mis en oeuvre même dans le cas où les parties sensibles au collage ne sont pas disposées à la surface de la structure.

**DOCUMENTS CITES DANS LA PRESENTE DESCRIPTION**

(1)

Supercritical Carbon Dioxide Drying Microstructures, G. Mulhern et al., 7th International Conference on Solid State Sensors and Actuators, pp. 296 à 299

(2)

EP-A-0 386 464

(3)

US-A-4 999 735

(4)

Surface Roughness Modification of Interfacial Contacts in Polysilicon Microstructures, R.L. Alley et al., 7th International Conference on Solid State Sensors an Actuators, pp. 288 à 291.

(5)

US-5-258-097

**Revendications**

1. Procédé de désolidarisation d'une couche utile (120) reliée initialement à un substrat (100) par une couche sacrificielle (110), caractérisé en ce qu'il comporte les étapes suivantes :

   - première gravure partielle et sélective de la couche sacrificielle (110) en laissant subsister entre le substrat et la couche utile au moins un pavé (140) formant un espaceur,
   - deuxième gravure sélective de la couche utile (120) et/ou du substrat (100) en utilisant l'espaceur (140) comme masque de façon à former au moins une butée (150, 151) dans ladite couche utile (120) et/ou le substrat (100),
   - élimination dudit espaceur (140).

2. Procédé selon la revendication 1, caractérisé en ce qu'on effectue la première et la deuxième gravures par voie humide à travers au moins une ouverture (132) pratiquée dans la couche utile (120).

3. Procédé selon la revendication 2, caractérisé en ce que la première gravure est effectuée, à partir de chaque ouverture, sur une distance D sensiblement égale à $\frac{L - e}{2}$, où L est la distance maximale entre des ouvertures (132) voisines et e une dimension caractéristique désirée des butées (140).

4. Procédé de fabrication d'une structure comportant une couche utile (120) maintenue à distance d'un substrat par des butées formées dans la couche utile et/ou le substrat, caractérisé en ce qu'il comporte :

   - la formation d'une structure initiale comportant un empilement du substrat (100), d'une couche sacrificielle (110) et de la couche utile (120), la couche sacrificielle reliant la couche utile au substrat, et
   - la désolidarisation de la couche utile du substrat conformément au procédé de la revendication 1.

5. Procédé de fabrication selon la revendication 4, caractérisé en ce que la structure initiale est du type silicium sur isolant.

6. Procédé de fabrication d'une structure selon la revendication 4 ou 5, caractérisé en ce qu'on équipe en outre la couche utile et le substrat de moyens électriques de mesure d'un déplacement relatif de cette couche utile par rapport au substrat sous l'effet d'une accélération, pour former un accéléromètre dont la masse mobile sensible est constituée par la couche utile.

**Claims**

1. Method of detaching a useful layer (120), initially connected to a substrate (100) by a sacrificial layer (110), characterized in that it comprises the following steps:

   - a first partial and selective etching of the sacrificial layer (110) leaving at least one paving (140) to survive forming a spacer between the substrate and the useful layer,
   - a second selective etching of the useful layer (120) and/or the substrate (100) using the spacer (140) as a mask so as to form at least one abutment (150, 151) in said useful layer (120) and/or the substrate (100),
   - removal of said spacer (140).

2. Method according to claim 1, characterized in that the first and the second etchings are carried out by a wet route through at least one opening (132) made in the useful layer (120).

**3.** Method according to claim 2, characterized in that the first etching is carried out, starting from each opening, over a distance D approximately equal to (L-e)/2, where L is the maximum distance between neighbouring openings (132) and e is a desired characteristic dimension of the abutments (140).

**4.** Method of manufacturing a structure comprising a useful layer (120) held at a distance from a substrate by abutments formed in the useful layer and/or substrate, characterized in that it comprises

- the formation of an initial structure comprising a stack of substrate (100), sacrificial layer (110) and a useful layer (120), the sacrificial layer connecting the useful layer to the substrate, and
- the detachment of the useful layer from the substrate in conformity with the method of claim 1.

**5.** Method of manufacture according to claim 4, characterized in that the initial structure is of the silicon on an insulator type.

**6.** Method of manufacturing a structure according to claim 4 or 5, characterized in that, in addition, the useful layer and the substrate are equipped with electrical means for measuring a relative displacement of this useful layer with respect to the substrate by an acceleration, in order to form an accelerometer in which the useful layer is the mobile sensitive mass.

**Patentansprüche**

**1.** Verfahren zur Loslösung einer nützlichen Schicht (120), die ursprünglich durch eine Opferschicht (110) mit einem Substrat (100) verbunden ist, **dadurch gekennzeichnet,** dass es die folgenden Schritte umfasst:

- ein erstes partielles und selektives Ätzen der Opferschicht (110), wobei man zwischen dem Substrat und der nützlichen Schicht wenigstens ein Element (140) stehen lässt, das einen Abstandshalter bildet,
- ein zweites selektives Ätzen der nützlichen Schicht (120) und/oder des Substrats (100), indem man den Abstandshalter (140) als Maske benutzt, um wenigstens einen Anschlag (150, 151) in der nützlichen Schicht (120) und/oder dem Substrat (100) zu bilden,
- Eliminieren des genannten Abstandshalters (140).

**2.** Verfahren nach Anspruch 1, dadurch gekennzeichnet, dass das erste und das zweite Ätzen mittels Nassverfahren durch wenigstens eine Öffnung (132) erfolgt, die in der nützlichen Schicht (120) vorgesehen ist.

**3.** Verfahren nach Anspruch 2, dadurch gekennzeichnet, dass das erste Ätzen von jeder Öffnung über eine Distanz D im Wesentlichen gleich $\frac{L-e}{2}$ erfolgt, wobei L die maximale Distanz zwischen benachbarten Öffnungen (132) ist und e eine erwünschte charakteristische Dimension der Anschläge (140).

**4.** Herstellungsverfahren einer Struktur mit einer nützlichen Schicht (120), die von einem Substrat durch Anschläge beabstandet ist, die in der nützlichen Schicht und/oder dem Substrat ausgebildet sind, dadurch gekennzeichnet, dass es umfasst:

- die Ausbildung einer Anfangsstruktur mit einem Stapel aus dem Substrat (100), einer Opferschicht (110) und der nützlichen Schicht (120), wobei die Opferschicht die nützliche Schicht mit dem Substrat verbindet, und
- die Loslösung der nützlichen Schicht von dem Substrat nach dem Verfahren des Anspruch 1.

**5.** Herstellungsverfahren nach Anspruch 4, dadurch gekennzeichnet, dass die Anfangsstruktur vom Typ Silicium auf Isolator ist.

**6.** Herstellungsverfahren einer Struktur nach dem Anspruch 4 oder 5, dadurch gekennzeichnet, dass man außerdem die nützliche Schicht und das Substrat mit elektrischen Einrichtungen zum Messen einer Relativbewegung dieser nützlichen Schicht unter der Wirkung einer Beschleunigung in Bezug auf das Substrat ausstattet, um einen Beschleunigungsmesser herzustellen, dessen empfindliche bewegliche Masse durch die nützliche Schicht gebildet wird.

FIG. 1

FIG. 2

FIG. 3

FIG. 4

FIG. 5

FIG. 6

FIG. 7

FIG. 8